# EUROPÄISCHE PATENTANMELDUNG

(11) **EP 3 522 499 A1**
(43) Veröffentlichungstag der Anmeldung: **07.08.2019**
(21) Anmeldenummer: 19153858.6
(22) Anmeldetag: 28.01.2019
(51) Int. Cl.: H04L 29/08, G08B 1/08, H04L 29/06, G06F 3/14, G01R 31/02, G08C 17/02

(54) **KOMMUNIKATIONSSYSTEM BASIEREND AUF LORAWAN**

(30) Priorität: 02.02.2018 DE 102018201636
(71) Anmelder: Stadtwerke Karlsruhe GmbH, 76185 Karlsruhe (DE)
(72) Erfinder: Bastian, Uwe, 76532 Baden-Baden (DE)
(74) Vertreter: Grünecker Patent- und Rechtsanwälte PartG mbB

(57) **Zusammenfassung**

Die Erfindung umfasst eine Kommunikationsvorrichtung (1) umfassend eine Steuereinrichtung (2), eine Empfangseinrichtung (3), die ausgebildet ist, ein Kommunikationssignal über ein Long Range Wide Area Netzwerk, LoRaWAN, zu empfangen und an die Steuereinrichtung (2) zu übermitteln, und eine Anzeigeeinrichtung (5), die ausgebildet ist, Informationen basierend auf einem Anzeigesignal der Steuereinrichtung (2) anzuzeigen, wobei die Steuereinrichtung (2) ausgebildet ist, das von der Empfangseinrichtung (3) übermittelte Kommunikationssignal in ein Anzeigesignal umzuwandeln und an die Anzeigeeinrichtung (5) zu übermitteln.

## Beschreibung

Die Erfindung betrifft eine Kommunikationsvorrichtung, ein Kommunikationssystem und ein Verfahren zum Empfangen beziehungsweise Übermitteln von Text, Abbildungen und/oder Videos.

Die moderne Gesellschaft ist stark von funktionierenden Kommunikationssystemen abhängig. Insbesondere bei größeren Notfällen ist es sowohl für Einsatzkräfte als auch für systemrelevante Betriebe, beispielsweise Stromversorger, entscheidend, eine gewisse Kommunikationsfähigkeit aufrechterhalten zu können. Insbesondere bei großflächigen Stromausfällen erweist sich dies als schwierig. Mobilfunknetze benötigen insbesondere in der Stadt eine Vielzahl von Basisstationen. Es hat sich als unwirtschaftlich herausgestellt, die Basisstationen mit einer unterbrechungsfreien Stromversorgung auszustatten. Bei einem großflächigen Stromausfall fällt daher auch das Mobilfunknetz aus. Auch die klassische Telefonie wird mehr und mehr durch Internet-Protokoll (IP) Telefonie abgelöst. IP Telefone sind ebenfalls auf eine externe Stromversorgung angewiesen. Üblicherweise wird daher Bündelfunk eingesetzt, um auch in Ausnahmesituationen die Kommunikation aufrechterhalten zu können.

Aufgabe der vorliegenden Erfindung ist es, eine weitere alternative Kommunikationsmöglichkeit bereitzustellen, welche insbesondere die Möglichkeit bietet, auch bei Stromausfällen eingesetzt zu werden.

Diese Aufgabe wird durch eine Kommunikationsvorrichtung nach Anspruch 1, durch ein Kommunikationssystem nach Anspruch 6 sowie durch Verfahren zum Übermitteln bzw. Empfangen von Text, Abbildungen und/oder Videos gemäß den Ansprüchen 9 und 10 gelöst. Vorteilhafte Weiterbildungen der Erfindung sind in den abhängigen Ansprüchen angegeben.

Gemäß der Erfindung ist es also vorgesehen, ein Long Range Wide Area Netzwerk, LoRaWAN, zu verwenden, um Kommunikationssignale, insbesondere zum Übertragen von Text, Abbildungen und/oder Videos zu übermitteln. Bei LoRaWAN handelt es sich um ein Netzwerkprotokoll für Funkübertragungen, welches für die Kommunikation im "Internet der Dinge" entwickelt wurde. LoRaWAN benötigt daher nur sehr wenig Energie, ermöglicht aber eine Übertragung über verhältnismäßig große Reichweiten - in der Stadt sind 2 - 10 Kilometer möglich. LoRaWAN wird bislang eingesetzt, um Sensoren drahtlos zu vernetzen. Üblicherweise sind die Systeme aufgrund ihres niederen Energieverbrauchs und der geringeren Anzahl an erforderlichen Gateways mit einer unterbrechungsfreien Stromversorgung, USV, gekoppelt. Durch die vorliegende Erfindung wird also nicht nur ein neues Kommunikationssystem bereitgestellt, es wird üblicherweise auch aufgrund der regelmäßig eingesetzten unterbrechungsfreien Stromversorgung bei Stromausfällen betriebsfähig sein.

Durch die Verwendung eines LoRaWAN-Netzwerkes ist außerdem ein zuverlässiger Empfang auch in Gebäuden möglich, da die für LoRaWAN genutzten Frequenzen eine bessere Durchdringung von Wänden ermöglichen als beispielsweise die für Mobiltelefonie genutzten Frequenzen.

Als "LoRaWAN" wird insbesondere ein Netzwerkprotokoll für Funkübertragungen bezeichnet. Genutzt werden unterschiedliche Frequenzbereiche der ISM("Industrial, Scientific and Medical")-Bänder. Beispielsweise sind Frequenzen von 433 MHz, 868 MHz und 915 MHz in Verwendung. In der Bundesrepublik Deutschland wird eine Frequenz von 868 MHz verwendet. Die erfindungsgemäß genutzte Frequenz kann also insbesondere bei 433 MHz, 868 MHz und/oder 915 MHz liegen. Ein LoRaWAN-Netzwerk ist üblicherweise sternförmig aufgebaut. Endgeräte kommunizieren mit Gateways, welche die Daten an einen Netzwerkserver übermitteln. Das LoRaWAN-Netzwerk, kann also wenigstens ein Gateway und wenigstens einen Netzwerkserver umfassen. Der Netzwerkserver kann über eine Schnittstelle verfügen, über die Anwendungsrechner auf den Netzwerkserver zugreifen können.

Die Kommunikationsvorrichtung kann Eingabemittel umfassen, insbesondere einen Taster, zum Bestätigen der Kenntnisnahme der auf der Anzeigeeinrichtung angezeigten, auf dem Kommunikationssignal basierenden Informationen durch eine Bedienperson, wobei die Kommunikationsvorrichtung ausgebildet ist, ein Empfangsbestätigungssignal über das LoRaWAN an ein Gateway zu übermitteln, wenn die Eingabemittel zum Bestätigen betätigt werden. Vom Gateway kann das Empfangsbestätigungssignal an einen Netzwerkserver weitergeleitet werden. Auf diese Weise kann sichergestellt werden, dass die übermittelte Kommunikation beim Empfänger angekommen ist. Wenn die Bedienperson beispielsweise die auf der Anzeigeeinrichtung angezeigte Information sieht, kann sie über die Eingabemittel den Erhalt der Nachricht bestätigen.

Das Kommunikationssignal kann durch das Gateway an die Kommunikationsvorrichtung gesendet werden. Das Gateway kann das Kommunikationssignal wiederholt an die Kommunikationsvorrichtung übermitteln, insbesondere bis zum Erhalt des Empfangsbestätigungssignals.

Die einfachste Lösung für die Eingabemittel ist ein Taster. Es sind jedoch auch andere Eingabemittel denkbar. Beispielsweise kann die Anzeigeeinrichtung als berührungsempfindliche Anzeigeeinrichtung (Touchscreen) ausgebildet sein.

Die Kommunikationsvorrichtung kann außerdem eine Signalgebeeinrichtung umfassen, die ausgebildet ist, ein Audiosignal und/oder ein haptisches Signal auszugeben, wenn ein Kommunikationssignal empfangen wird. Auf diese Weise kann die Bedienperson zuverlässig auf den Eingang des Kommunikationssignals aufmerksam gemacht werden, wie dies auch bei Mobiltelefonen der Fall ist. Die Signalgebeeinrichtung kann also insbesondere einen Lautsprecher und/oder eine Vibrationseinheit für einen Vibrationsalarm umfassen.

Die Kommunikationsvorrichtung kann außerdem eine Sendeeinrichtung umfassen, die ausgebildet ist, Signale drahtlos über das LoRaWAN Netzwerk an eine externe Empfangseinheit, insbesondere an ein Gateway, zu übermitteln, wobei die Sendeeinrichtung zum periodischen oder aperiodischen Senden eines Ausgangssignals, insbesondere eines Keepalive Signals, ausgebildet ist, und wobei die Empfangseinrichtung ausgebildet ist, ein Kommunikationssignal unmittelbar nach dem Senden des Ausgangssignals zu empfangen und ansonsten zwischen dem periodischen oder aperiodischen Senden des Ausgangssignals in einem Standby-Modus verbleibt. Insbesondere durch das Keepalive Signal kann sichergestellt werden, dass eine Verbindung zwischen der externen Empfangseinheit und der Kommunikationsvorrichtung besteht. Gleichzeitig kann der Energieverbrauch der Kommunikationsvorrichtung optimiert werden. Diese Ausführungsform macht sich zunutze, dass LoRaWAN Kommunikation nach dem ALOHA-Zugriffsverfahren ermöglicht. Dabei sendet das Gerät sein Ausgangssignal an das Gateway, gefolgt von einem oder mehreren, insbesondere zwei, Downloadfenstern, die für den Datenempfang genutzt werden können.

Die Sendeeinrichtung kann insbesondere mit der Empfangseinrichtung als Sende-Empfangs-Einrichtung (Transceiver) kombiniert sein. Die Sende-Empfangs-Einrichtung kann mit einer Antenne verbunden sein.

Bei der Anzeigeeinrichtung kann es sich um eine Matrixanzeige handeln, insbesondere eine Flüssigkristallanzeige oder eine Organische Leuchtdioden, OLED, Anzeige. Wie zuvor ausgeführt, kann die Anzeigeeinrichtung insbesondere als Touchscreen ausgebildet sein. Dadurch ist eine einfache Bedienung der Kommunikationsvorrichtung möglich, ähnlich der eines Mobiltelefons.

Zusätzlich kann neben der LoRaWAN Sende-Empfangs-Einrichtung eine oder mehrere weitere Sende-Empfangs-Einrichtungen zum drahtlosen Empfangen und Übertragen von Daten vorgesehen sein, beispielsweise ein Bluetooth Modul und/oder ein Wireless Local Area Network, WLAN, Modul. Dadurch kann die Kommunikationsvorrichtung vielfältiger eingesetzt werden.

Die Kommunikationsvorrichtung kann außerdem eine Anschlusseinheit zum Verbinden mit einer externen Energiequelle, insbesondere Spannungsquelle, umfassen. Die Anschlusseinheit kann insbesondere ein Netzteil umfassen.

Die Kommunikationsvorrichtung kann außerdem einen oder mehrere Pufferakkus und eine Ladeelektronik zum Laden der Pufferakkus umfassen. Dadurch ist es möglich, die Kommunikationsvorrichtung auch ohne externe Energieversorgung, also mobil, zu betreiben. Ein Vorteil der Übertragung in LoRaWAN-Netzwerken ist der verhältnismäßig geringe Stromverbrauch (etwa 100 mA für eine Übermittlung). Durch die Pufferakkus kann der Betrieb über längere Zeit aufrechterhalten bleiben. Durch die Ladeelektronik können der eine oder die mehreren Pufferakkus im Falle einer Verbindung mit einer externen Energiequelle wieder geladen werden. Als "Pufferakku" oder Pufferakkumulator wird hierin ein wiederaufladbarer Energiespeicher bezeichnet, der aus einer oder mehreren zusammengeschalteten Sekundärzellen besteht. Beispielsweise kann der wenigstens eine Pufferacku zwei wiederaufladbare Sekundärzellen (z.B. IEC Größe R6) umfassen.

Die Kommunikationsvorrichtung kann außerdem ein Modul zur Positionsbestimmung umfassen, beispielsweise ein Global Positioning System, GPS, Modul. Die Kommunikationsvorrichtung kann ausgebildet sein, die durch das Modul zur Positionsbestimmung bestimmte Position periodisch oder aperiodisch, beispielsweise zu bestimmten Zeiten, an eine externe Empfangseinheit zu übermitteln. Dadurch kann die Kommunikationsvorrichtung geortet werden.

Die Erfindung stellt außerdem ein Kommunikationssystem nach Anspruch 6 bereit, umfassend eine oben beschriebene Kommunikationsvorrichtung, einen Serverrechner und eine Sende-Empfangsvorrichtung (auch als Gateway bezeichnet), die mit dem Serverrechner verbunden und so ausgebildet ist, dass der Serverrechner mit der Kommunikationsvorrichtung über ein Long Range Wide Area Netzwerk, LoRaWAN, kommunizieren kann.

Die Kommunikationsvorrichtung kann eines oder mehrere der oben genannten Merkmale aufweisen. Der Serverrechner kann insbesondere das Kommunikationssignal erzeugen und mittels der Sende-Empfangsvorrichtung an die Kommunikationsvorrichtung übermitteln. Der Serverrechner und/oder die Sende-Empfangsvorrichtung können auch der oben genannten externen Empfangseinheit entsprechen, an die beispielsweise das Empfangsbestätigungssignal, ein Positionssignal und/oder die periodisch oder aperiodisch gesendeten Ausgangssignale übermittelt werden.

Der Serverrechner und die Sende-Empfangsvorrichtung können mit einer unterbrechungsfreien Stromversorgung, USV, gekoppelt sein. Dadurch ist es möglich, die Kommunikation auch im Falle einer Unterbrechung der externen Stromversorgung aufrechtzuerhalten. Die Kommunikationsvorrichtung kann für diesen Zweck, wie oben ausgeführt, insbesondere einen oder mehrere Pufferakkus und eine Ladeelektronik zum Laden der Pufferakkus umfassen.

Eine besonders vorteilhafte Ausführung kann sich ergeben, wenn das oben beschriebene Kommunikationssystem außerdem eine Vorrichtung zur Überwachung einer Transformatorenstation umfasst, wobei die Vorrichtung zur Überwachung einer Transformatorenstation wenigstens einen Sensor zur Erfassung eines Betriebszustandes einer Transformatorenstation und eine mit dem Sensor verbundene Steuerung umfasst, welche ausgebildet ist, basierend auf einem Messsignal des Sensors ein Übertragungssignal zur drahtlosen Übermittlung über das LoRaWAN Netzwerk zu erzeugen, wobei die Steuerung außerdem eine Übertragungseinheit umfasst, die ausgebildet ist, das Übertragungssignal drahtlos über das LoRaWAN Netzwerk an den Serverrechner zu übermitteln.

Bei dem wenigstens einen Sensor kann es sich beispielsweise um einen Kurzschlusssensor und/oder Erdschlusssensor handeln. Besonders bei Kurzschlüssen oder Erdschlüssen in Transformatorenstationen kann es häufig zu großflächigen Stromausfällen kommen. In diesem Fall bricht, wie eingangs erwähnt, auch die Kommunikation mittels Mobiltelefonen zusammen. Die Vorrichtung zur Überwachung einer Transformatorenstation kann ebenfalls über einen oder mehrere Pufferakkus betrieben werden. In diesem Fall kann das Übertragungssignal über die USV gepufferte Sende-Empfangsvorrichtung an den ebenfalls USV gepufferten Serverrechner übermittelt werden. Dieser kann dann wiederum ein Kommunikationssignal an die Kommunikationsvorrichtung übermitteln, welche ebenfalls über Pufferakkus verfügt. Die Kommunikationsvorrichtung kann beispielsweise einem Bereitschaftsmitarbeiter des Energieversorgers zugeordnet sein, der dadurch effizient über den Fehler in der Transformatorenstation informiert wird und entsprechende Reparaturmaßnahmen einleiten kann. Beispielsweise kann das Kommunikationssignal, welches der Serverrechner an die Kommunikationsvorrichtung überträgt, eine Identifikation der defekten Transformatorenstation sowie optional einen Hinweis auf den Betriebszustand der Transformatorenstation, beispielsweise Vorliegen eines Kurzschlusses/Erdschlusses, enthalten.

Ein Kurzschlusssensor und ein Erdschlusssensor können insbesondere über einen potentialfreien Relaiskontakt mit der Steuerung gekoppelt sein.

Bei dem wenigstens einen Sensor kann es sich aber auch um einen Sensor zur Erfassung der Stromstärke und/oder Spannung in jeweils einem Leitungsabschnitt einer Transformatorenstation handeln. Der wenigstens eine Sensor kann insbesondere einen Messwandler oder Messumformer umfassen. Insbesondere ist es dadurch möglich, die hohen elektrischen Stromstärken oder elektrischen Spannungen, die in Transformatorenstationen auftreten, in eine geringere Stromstärke/Spannung zu wandeln. Diese geringeren Ströme/Spannungen können dann einfacher verarbeitet werden. Insbesondere kann es sich bei dem jeweiligen Messwandler oder Messumformer um einen Wechselstromwandler, insbesondere einen Kleinsignalwandler handeln. Solche Messwandler sind beispielsweise in der Mittelspannungsschaltanlage der Transformatorenstation anwendbar. Ein Beispiel für einen solchen Wechselstromwandler sind sogenannte Rogowski-Spulen. Der wenigstens eine Sensor kann daher eine Rogowski-Spule umfassen. Rogowski-Spulen haben den Vorteil, dass sie ohne aufwändige Montagearbeiten angelegt und wieder entfernt werden können.

Das Übertragungssignal kann in diesem Fall einen Stromstärkewert und/oder Spannungswert und eine Identifikation des zugehörigen Leitungsabschnitts umfassen. Der Stromstärkewert und/oder Spannungswert kann ein Mittelwert über einen vorgegebenen Zeitraum sein. Der vorgegebene Zeitraum kann frei konfigurierbar sein. Beispielsweise kann der vorgegebene Zeitraum im Bereich von einer Minute bis zu einer Stunde liegen, beispielsweise bei 15 Minuten. Durch die Übertragung von Mittelwerten kann nicht nur der Datenverkehr optimiert werden, sondern es werden dadurch auch kleinere Schwankungen oder kurzfristige Strom-/Spannungsspitzen geglättet.

Alternativ oder zusätzlich zum Mittelwert ist es auch möglich, einen Maximalwert und/oder Minimalwert des Stromstärkewerts und/oder des Spannungswerts zu ermitteln und mit dem Übertragungssignal zu übermitteln.

Die Steuerung kann also ausgebildet sein, einen Mittelwert, einen Maximalwert und/oder einen Minimalwert des Stromstärkewerts und/oder des Spannungswerts in einem vorherbestimmten Zeitintervall zu bestimmen und in ein Übertragungssignal zu integrieren.

Das Übertragungssignal kann außerdem einen Zeitstempel umfassen, welcher den Zeitpunkt oder das Zeitintervall für die Bestimmung des übermittelten Stromstärkewerts und/oder Spannungswerts angibt.

Es ist jedoch auch denkbar, dass auf Seiten des Serverrechners die eingehenden Übertragungssignale entsprechend zeitlich sortiert oder zugeordnet werden. In diesem Fall ist es nicht erforderlich, dass die Übertragungssignale separate Zeitstempel umfassen.

Abhängig von dem übermittelten Stromstärkewert und/oder Spannungswert kann ein Betriebszustand der Transformatorenstation ermittelt werden, basierend darauf wiederum das Kommunikationssignal an die Kommunikationsvorrichtung erstellt werden kann.

Die Erfindung stellt außerdem ein Verfahren zum Übermitteln von Text, Abbildungen und/oder Videos über ein Long Range Wide Area Netzwerk, LoRaWAN, gemäß Anspruch 9 und ein Verfahren zum Empfangen von Text, Abbildungen und/oder Videos über ein Long Range Wide Area Netzwerk, LoRaWAN, gemäß Anspruch 10 bereit. Diese Verfahren können insbesondere mit einer Kommunikationsvorrichtung und/oder einem Kommunikationssystem, wie oben beschrieben, durchgeführt werden. Die Kommunikationsvorrichtung und/oder das Kommunikationssystem können eines oder mehrere der oben genannten Merkmale aufweisen.

Im Prinzip könnten auch Audiosignale, insbesondere Sprachsignale, übertragen werden. Da LoRaWAN allerdings nicht für den Vollduplex Betrieb ausgebildet ist, ist eine Kommunikation wie in der Telefonie nicht möglich. Videos können Bild- und Audiodaten oder nur Bilddaten umfassen.

Aufgrund der Datenraten von LoRaWAN von 0,3 kbit/s bis 50 kbit/s, ist die Übertragung von großen Datenmengen langsam. Die oben beschriebene Vorrichtung, das System und die Verfahren eignen sich also besonders für kurze Benachrichtigungen.

Die Kommunikation im LoRaWAN kann zweifach mit 128 bit Advanced Encryption Standard, AES, verschlüsselt sein.

Weitere Merkmale und Vorteile der Erfindung werden nachfolgend anhand der beispielhaften Figuren beschrieben. Dabei zeigt:
- Figur 1: den schematischen Aufbau einer Kommunikationsvorrichtung gemäß der Erfindung;
- Figuren 2 und 3: eine Illustration eines beispielhaften Kommunikationssystems;
- Figur 4: eine Illustration einer beispielhaften Vorrichtung zur Überwachung einer Transformatorenstation; und
- Figur 5: den schematischen Aufbau einer Transformatorenstation.

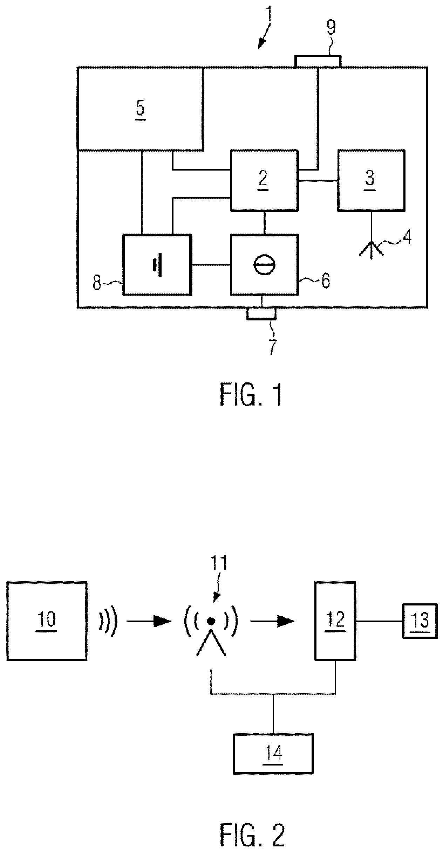

Die beispielhafte Kommunikationsvorrichtung 1 der Figur 1 umfasst eine Steuereinrichtung 2, eine Empfangseinrichtung 3, die ausgebildet ist, ein Kommunikationssignal über ein Long Range Wide Area Netzwerk, LoRaWAN, zu empfangen und an die Steuereinrichtung 2 zu übermitteln, und eine Anzeigeeinrichtung 5, die ausgebildet ist, Informationen basierend auf einem Anzeigesignal der Steuereinrichtung 2 anzuzeigen. Die Empfangseinrichtung 3 ist zum Empfangen des Kommunikationssignals insbesondere mit einer Antenne 4 gekoppelt. Die Steuereinrichtung 2 ist wiederum ausgebildet, das von der Empfangseinrichtung 3 übermittelte Kommunikationssignal in ein Anzeigesignal umzuwandeln und an die Anzeigeeinrichtung 5 zu übermitteln.

Das Anzeigesignal enthält die im Kommunikationssignal enthaltene Information, beispielsweise Text, ein Bild und/oder ein Video, in einer Form, dass die Information auf der Anzeigeeinrichtung 5 für eine Bedienperson dargestellt werden kann. Das Anzeigesignal kann auch mehrere Teilsignale umfassen, die zur Ansteuerung der Anzeigeeinrichtung 5 in an sich bekannter Weise erforderlich sind.

Bei der Steuereinrichtung 2 handelt es sich insbesondere um einen Prozessor, der mit einem flüchtigen Arbeitsspeicher und/oder permanenten Speicher gekoppelt sein kann. Die Empfangseinrichtung 3 kann insbesondere einer Sende-Empfangs-Einrichtung entsprechen, die zur Kommunikation gemäß dem LoRaWAN-Standard ausgebildet ist.

Bei der Anzeigeeinrichtung 5 kann es sich um ein Matrix-Display, insbesondere eine OLED-Anzeige, handeln. Gemäß einem Ausführungsbeispiel kann es sich bei der Anzeigeeinrichtung 5 auch um einen Touchscreen handeln.

Ebenfalls in Figur 1 gezeigt ist eine Energiequelle 6, welche die elektrischen Verbraucher der Kommunikationsvorrichtung 1 mit Energie versorgt. Dafür kann die Energiequelle 6 über einen Anschluss 7 mit einer externen Stromversorgung verbunden sein. Außerdem zeigt die schematische Ansicht der Figur 1 eine Puffereinheit 8, die wenigstens einen Pufferakku und eine Ladeelektronik für den Pufferakku umfasst. Durch diese Puffereinheit 8 können die Komponenten der Kommunikationsvorrichtung 1 mit elektrischer Energie versorgt werden, wenn die externe Stromversorgung gewollt oder ungewollt unterbrochen wird. Die Puffereinheit kann insbesondere so konzipiert sein, dass sie eine Energieversorgung über mehrere Stunden bis Tage sicherstellen kann. Dadurch ist eine mobile Verwendung der Kommunikationsvorrichtung 1, wie man es etwa von Mobiltelefonen kennt, möglich. In der schematischen Abbildung der Figur 1 sind nicht alle Verbindungen zwischen der Energiequelle 6 bzw. der Puffereinheit 8 und den jeweiligen Verbrauchern dargestellt, um die Abbildung übersichtlich zu halten. Grundsätzlich sollen alle elektrischen Verbraucher mit der Energiequelle 6 und der Puffereinheit 8 gekoppelt sein, um wahlweise eine Stromversorgung über die externe Stromquelle oder über die Puffereinheit 8 zu ermöglichen.

In Figur 1 ist außerdem ein Taster 9 gezeigt, der mit der Steuereinrichtung 2 verbunden ist. Über diesen Taster 9 kann eine Bedienperson die Kenntnisnahme der auf der Anzeigeeinrichtung 5 angezeigten, auf dem Kommunikationssignal basierenden Informationen, bestätigen. Die Kommunikationseinrichtung 1 kann dann ausgebildet sein, ein Empfangsbestätigungssignal über das LoRaWAN an den Sender des Kommunikationssignals zu übermitteln. Dafür kann die Empfangseinrichtung 3, wie oben ausgeführt, als Sende-Empfangs-Einrichtung ausgebildet sein, welche über die Antenne 4 ein entsprechendes Empfangsbestätigungssignal über das LoRaWAN Netzwerk sendet, wenn die Steuereinrichtung 2 ein solches nach Betätigen des Tasters 9 erzeugt und an die Sende-Empfangs-Einrichtung 3 zum Übertragen übermittelt.

Nicht dargestellt in Figur 1 aber ebenfalls möglich ist, dass die Kommunikationsvorrichtung 1 eine Signalgebeeinrichtung umfasst, die ausgebildet ist, ein Audiosignal und/oder ein haptisches Signal auszugeben, wenn ein Kommunikationssignal empfangen wird. Dadurch kann eine Bedienperson auf eine eingehende Nachricht aufmerksam gemacht werden. Beispielsweise können ein Lautsprecher und/oder eine Vibrationseinheit vorgesehen sein.

Die Figuren 2 - 5 dienen der Illustration einer vorteilhaften Verwendung der Kommunikationsvorrichtung 1 aus Figur 1 sowie der Illustration eines Kommunikationssystems, in welches die Kommunikationsvorrichtung 1 der Figur 1 eingebettet oder integriert sein kann.

Insbesondere zeigt Figur 2 eine Sende-Empfangsvorrichtung 11, auch Gateway genannt, die mit einem Serverrechner 12 (Netzwerkserver) verbunden ist. Der Serverrechner 12 und die Sende-Empfangsvorrichtung 11 sind mit einer unterbrechungsfreien Stromversorgung, USV, 14 verbunden. Dadurch ist es möglich, den Betrieb des Serverrechners 12 und der Sende-Empfangsvorrichtung 11 aufrechtzuerhalten, auch wenn durch einen Stromausfall die externe Energieversorgung abbricht. Ein Anwenderrechner 13 kann über eine Schnittstelle auf den Serverrechner 12 zugreifen und Nachrichten zur Übermittlung über die Sende-Empfangsvorrichtung 11 konfigurieren bzw. über die Sende-Empfangsvorrichtung 11 erhaltene Nachrichten auslesen. Auch der Anwenderrechner 13 kann über eine eigene Stromversorgung verfügen, beispielsweise einen oder mehrere Akkus.

In Figur 2 ist außerdem eine Steuerung 10 einer Vorrichtung zur Überwachung einer Transformatorenstation schematisch dargestellt. Diese übermittelt Informationen über den Betriebszustand einer Transformatorenstation über das LoRaWAN Netzwerk, insbesondere über die Sende-Empfangsvorrichtung 11 an den Serverrechner 12. Beispielsweise kann in der Transformatorenstation, welcher die Steuerung 10 zugeordnet ist, ein Kurzschluss auftreten. Die Steuerung 10 kann dann ein Übertragungssignal übermitteln, mit welchem beispielsweise der Betriebszustand, "Kurzschluss", und eine Identifikation der Transformatorenstation übermittelt werden.

Der Serverrechner 12 oder der Anwenderrechner 13 kann bestimmen, welcher Bereitschaftsmitarbeiter des Energieversorgers für die Behebung des Schadens zuständig ist. Gegebenenfalls kann diese Information auch über den Anwenderrechner 13 beispielsweise durch die Leitstelle in den Serverrechner 12 eingegeben werden.

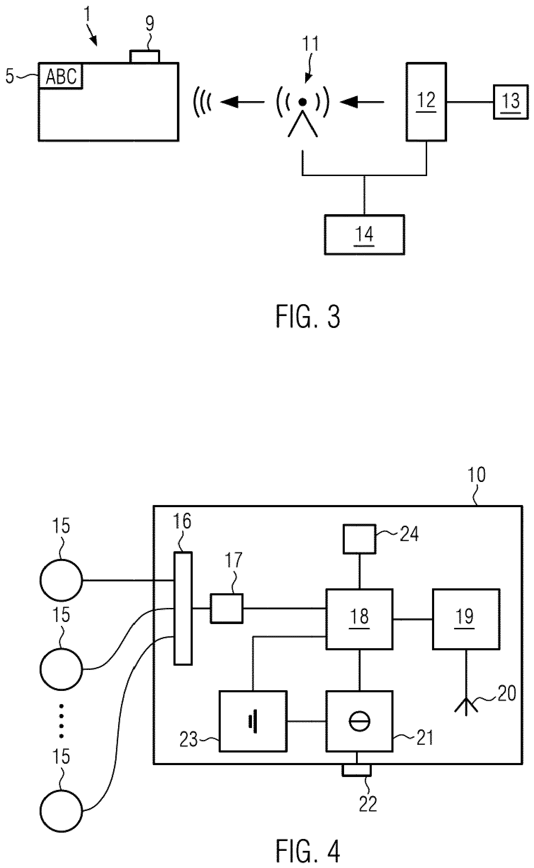

Wie in Figur 3 dargestellt kann der Serverrechner 12 dann ein entsprechendes Kommunikationssignal konfigurieren, welches an die Kommunikationsvorrichtung 1 des zuständigen Bereitschaftsmitarbeiters über die Sende-Empfangsvorrichtung 11 übermittelt wird. Nach Erhalt des Kommunikationssignals durch die Kommunikationsvorrichtung 1 kann die Information bezüglich der betroffenen Transformatorenstation und des entsprechenden Betriebszustandes auf der Anzeigeeinrichtung 5 zur Anzeige gebracht werden, wie oben genauer beschrieben. Der Bereitschaftsmitarbeiter kann den Erhalt der Nachricht dann über den Taster 9 bestätigen. In nicht dargestellter Weise kann die Kommunikationsvorrichtung 1 dann ein Empfangsbestätigungssignal über die Sende-Empfangsvorrichtung 11 an den Serverrechner 12 übermitteln. Der Serverrechner 12 und/oder die Sende-Empfangsvorrichtung 11 können konfiguriert sein, das Kommunikationssignal wiederholt zu übermitteln, insbesondere bis zum Erhalt einer entsprechenden Empfangsbestätigung.

Die Kommunikationsvorrichtung 1 kann insbesondere ausgebildet sein, periodisch oder aperiodisch, beispielsweise zu vorherbestimmten Zeitpunkten, ein Ausgangssignal zu senden, insbesondere ein Keepalive Signal. Ein solches kann beispielsweise alle 5 Minuten übermittelt werden. Die Kommunikationsvorrichtung 1 kann derart ausgebildet sein, dass deren Empfangseinrichtung ausgebildet ist, ein Kommunikationssignal unmittelbar nach dem Senden des Ausgangssignals zu empfangen und ansonsten zwischen dem periodischen und aperiodischen Senden des Ausgangssignals in einem Standby-Modus zu verbleiben. Dadurch kann die Kommunikationsvorrichtung 1 Energie einsparen. Hier kann eine Abwägung getroffen werden, zwischen einer kurzfristigen Benachrichtigung und einem effizienten Energiemanagement. Falls gewünscht, kann also das Keepalive Signals auch häufiger übertragen werden, beispielsweise jede Minute oder seltener, beispielsweise alle 15 Minuten.

Die Sende-Empfangsvorrichtung 11 kann konfiguriert sein, das Kommunikationssignal unmittelbar nach Erhalt eines Ausgangssignals zu senden.

In Figur 4 ist eine Vorrichtung zur Überwachung einer Transformatorenstation, wie sie im obigen Beispiel Verwendung finden kann, genauer gezeigt.

Die Vorrichtung umfasst Sensoren 15, die als Rogowski-Spulen ausgebildet sind. Die Rogowski-Spulen 15 sind leitend mit einem Eingang 16 einer Steuerung 10 verbunden. Der Eingang 16 ist bevorzugt ein analoger Eingang. Die empfangenen Signale werden dann über einen Analog-Digital-Wandler 17 an einen Prozessor 18 übermittelt. Der Prozessor 18 kann mit einer hier nicht dargestellten Speichereinheit versehen sein, um temporär oder dauerhaft empfangene oder berechnete Werte speichern zu können. In der schematischen Abbildung der Figur 4 ist nur ein Analog-Digital-Wandler 17 dargestellt. Tatsächlich ist jedoch für jeden Sensor 15 und den zugehörigen Anschluss im Eingang 16 ein Analog-Digital-Wandler vorgesehen. Neben dem Analog-Digital-Wandler 17 kann auch noch ein definierter Widerstand vorgesehen sein, um das von den Rogowski-Spulen gelieferte Stromstärkesignal in ein Spannungssignal umzuwandeln.

Der Prozessor 18 ist mit einer Übertragungseinheit 19 verbunden, welche wiederum mit einer Antenne 20 verbunden ist. Die Übertragungseinheit 19 ist in Verbindung mit der Antenne 20 ausgebildet, um Übertragungssignale, welche vom Prozessor 18 empfangen werden, über ein LoRaWAN-Netzwerk an eine externe Empfangseinheit zu übermitteln.

Der Prozessor 18 kann insbesondere ausgebildet sein, Mittelwerte der von den Sensoren 15 übermittelten und gegebenenfalls weiterverarbeiteten Messsignale zu bestimmen, so dass ein über eine vorbestimmte Zeitdauer gemittelter Stromstärkewert und/oder Spannungswert erhalten wird. Beispielsweise können die jeweiligen Werte über ein Zeitfenster von 15 Minuten gemittelt werden. Alle 15 Minuten kann dieser Mittelwert dann als Teil des Übertragungssignals durch die Übertragungseinheit 19 und die Antenne 20 übermittelt werden. Dadurch ist es möglich Informationen über den zeitlichen Verlauf der Stromstärke/Spannung zu erhalten. Durch die Mittelwertbildung kann der Netzwerkverkehr und die verbundene Datenmenge auf das erforderliche Maß eingestellt werden. Alternativ oder zusätzlich können auch Maximalwerte und/oder Minimalwerte übertragen werden.

Die Signalverarbeitung kann in einem konkreten Beispiel also wie folgt aussehen: Das analoge Signal der Sensoren wird mit einer Genauigkeit von mindestens 10 bit in einen digitalen Wert gewandelt. Die Erfassung und Umwandlung der Messwerte in Digitalwerte erfolgt im Sekundentakt. Hierbei wird der je Sensor auftretende Minimalwert und Maximalwert erfasst und gespeichert sowie ein Mittelwert der jeweiligen Messwerte gebildet. Diese Werte werden am Ende einer vorherbestimmten Periode (z.B. 15 min) übertragen. Daraus ergeben sich folgende Übertragungswerte für jeden der Sensoren: Minimum, Maximum, Durchschnitt, Datum, Uhrzeit und eine Identifikation des Leitungsabschnitts. Es versteht sich, dass die Erfindung in keiner Weise auf dieses konkrete Beispiel beschränkt ist.

Es ist denkbar, dass basierend auf den Messsignalen eines jeden der Sensoren ein eigenes Übertragungssignal übermittelt wird. Es kann jedoch auch nur ein Übertragungssignal für die Informationen bezüglich aller Sensoren konfiguriert werden.

Das System kann so ausgebildet sein, dass es periodisch oder zu vorherbestimmten Zeiten ein oder mehrere Übertragungssignale basierend auf den Messsignalen der Sensoren erstellt und übermittelt. Beispielsweise können alle 15 Minuten ein oder mehrere Übertragungssignale erstellt und übermittelt werden.

In Figur 4 ist außerdem eine Energiequelle 21 zu sehen, welche über einen Anschluss 22 mit einer externen Energiequelle verbunden sein kann. Im Normalbetrieb kann diese Energiequelle 21 die elektrischen Verbraucher der Steuerung 10 mit Energie versorgen. In der schematischen Abbildung der Figur 4 ist nur der Prozessor 18 und der später noch genauer spezifizierte Energiepuffer 23 mit der Energiequelle 21 verbunden. Tatsächlich kann die Energiequelle 21 jedoch mit allen elektrischen Verbrauchern der Steuerung 10 verbunden sein, so dass diese mit der erforderlichen Energie versorgt werden können.

Die eben erwähnte Puffereinheit 23 umfasst einen oder mehrere Pufferakkus und eine Ladeelektronik zum Laden der Pufferakkus. Im Falle eines Stromausfalls der externen Energiequelle kann die für die Funktion des Systems erforderliche Energie aus dem oder den Pufferakkus bezogen werden. Sobald die externe Energiequelle wieder zur Verfügung steht, kann die Ladeelektronik verwendet werden, um die Pufferakkus wieder zu laden. Auch hier kann die Puffereinheit 23 mit allen elektrischen Verbrauchern der Steuerung 10 verbunden sein, so dass diese mit der erforderlichen Energie versorgt werden können.

Figur 4 zeigt außerdem einen Anschluss 24 für einen externen Monitor. Dieser Anschluss 24 erlaubt es, die Messwerte der Sensoren auch vor Ort zur Anzeige zu bringen, und nicht nur für die Fernauslese bereitzustellen. Dies kann für die Kontrolle und Wartung der Transformatorenstation vorteilhaft sein.

Alternativ oder zusätzlich können neben der LoRaWAN Übertragungseinheit eine oder mehrere weitere Übertragungseinheiten zum drahtlosen Übertragen von Daten vorgesehen sein, beispielsweise eine Bluetooth Übertragungseinheit und/oder eine Wireless Local Area Network, WLAN, Übertragungseinheit. Die Steuerung kann so ausgebildet sein, dass sie über die eine oder mehrere weitere Übertragungseinheit Stromstärkewerte und/oder Spannungswerte, die von den Sensoren ermittelt wurden, oder daraus errechnete Werte, an ein externes Gerät übermittelt. Dadurch können die Werte auch auf einen mobilen Rechner, beispielsweise einem Smartphone oder einem Notebook, der sich insbesondere in der Nähe der Steuereinrichtung befindet, empfangen, gespeichert und/oder angezeigt werden. Im einfachsten Fall kann die Steuerung entsprechende Anzeigesignale übermitteln, sodass das externe Gerät gewissermaßen als externer Monitor fungiert.

Im Grunde kann eine Vorrichtung zur Überwachung einer Transformatorenstation, wie beispielsweise die in Figur 4 gezeigte Vorrichtung, auch als Kommunikationsvorrichtung im Sinne der Erfindung ausgebildet werden. Dafür muss lediglich eine Anzeigeeinrichtung vorgesehen werden, beispielsweise durch Kopplung mit dem Anschluss 24 in Figur 4. Außerdem muss die Übertragungseinheit als Sende-Empfangseinrichtung und so ausgebildet sein, dass sie ein Kommunikationssignal, das über ein LoRaWAN Netzwerk empfangen wird an den Prozessor 18 übermittelt. Der Prozessor 18 muss schließlich das Kommunikationssignal in ein Anzeigesignal umwandeln und an die Anzeigeeinrichtung zur Anzeige übermitteln. Auf diese Weise können einfach Nachrichten in Transformatorenstationen übermittelt werden, beispielsweise für dort tätige Wartungsmitarbeiter.

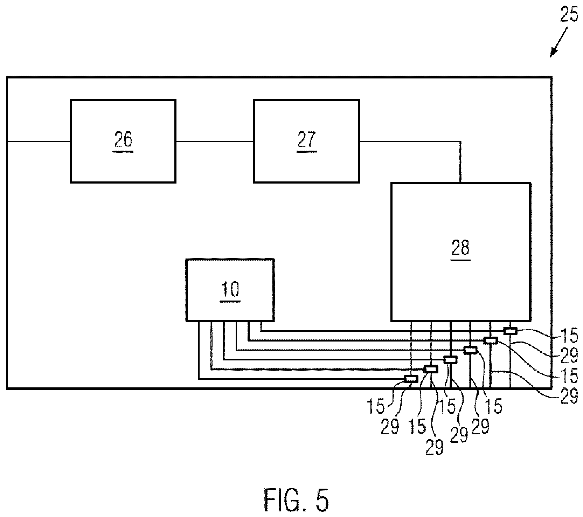

Figur 5 zeigt eine schematische Ansicht einer Transformatorenstation 25 mit einer darin angeordneten Vorrichtung zur Überwachung der Transformatorenstation 25.

Transformatorenstationen als solches sind bekannt. Sie dienen dazu, elektrische Energie aus dem Mittelspannungsnetz mit einer elektrischen Spannung von 10 bis 36 kV auf die in Niederspannungsnetzen verwendeten 400/230 V zu transformieren. Es sind Transformatorenstationen bekannt, die in begehbaren Gebäuden angeordnet sind. Es sind inzwischen allerdings auch nicht begehbare Lösungen bekannt, sogenannte "Kompakttransformatorenstationen" .

Die Transformatorenstation 25 umfasst in an sich bekannter Weise eine Mittelspannungsschaltanlage 26, welche über einen Eingang mit dem Mittelspannungsnetz verbunden ist. Die Mittelspannungsschaltanlage 26 ist mit einem Transformator 27 verbunden, welcher die Spannungsumwandlung von Mittelspannung auf Niederspannung realisiert. An dem Transformator 27 angeschlossen ist eine Niederspannungsverteilung 28, welche die elektrische Energie auf eine Mehrzahl von Ableitungen 29 verteilt. Beispielsweise kann jeder Ableitung 29 ein Straßenzug einer Ortschaft oder ein Gebäude, insbesondere ein Industriegebäude, entsprechen.

In Figur 5 ist eine Vorrichtung zur Überwachung der Transformatorenstation 25 vorgesehen, welche in diesem Beispiel sechs Sensoren 15 umfasst, mit denen die Stromstärke und/oder Spannung in jeweils einem separaten Leitungsabschnitt der Transformatorenstation 25 bestimmt werden kann. In dem Beispiel der Figur 5 sind die Sensoren 15 im Bereich der Abgänge 29 zum Niederspannungsnetz, also in oder unmittelbar nach der Niederspannungsschaltanlage 28 angeordnet. Dadurch kann ortsaufgelöst festgestellt werden, welche Stromstärken beispielsweise in einzelne Straßenzüge eingespeist werden.

Mit den Sensoreinrichtungen 15 verbunden ist eine Steuerung 10, welche ausgebildet ist, Messsignale der Sensoren 15 zu empfangen und in Übertragungssignale zur drahtlosen Übermittlung über ein Long-Range-Wireless-Area-Netzwerk, LoRaWAN, zu konvertieren. Die Übertragungssignale umfassen dabei jeweils einen Stromstärkewert und/oder Spannungswert und eine Identifikation des zugehörigen Leitungsabschnitts. Eine hier in Figur 5 nicht dargestellte Übertragungseinheit der Steuerung 10 ist ausgebildet, die ermittelten Übertragungssignale über das LoRaWAN-Netzwerk an eine externe Empfangseinheit zu übermitteln, beispielsweise über den Serverrechner an eine Leitstelle, die somit über jeden Abgang 29 der Transformatorenstation 25 aktuelle Informationen zum Betriebszustand fernauslesen kann. Basierend auf dem aktuellen Betriebszustand kann wie oben erwähnt ein Kommunikationssignal konfiguriert und an die Kommunikationsvorrichtung eines Bereitschaftsmitarbeiters übermittelt werden.

Es versteht sich, dass in den zuvor beschriebenen Ausführungsbeispielen genannte Merkmale nicht auf diese speziellen Kombinationen beschränkt und auch in beliebigen anderen Kombinationen möglich sind. Insbesondere ist der Einsatz der Kommunikationsvorrichtung nicht auf das angegebene Beispiel zur Überwachung von Transformatorenstationen beschränkt. Weiterhin versteht es sich, dass in den Figuren gezeigte Bauteile nur schematisch dargestellt sind.

## Patentansprüche

1. Kommunikationsvorrichtung (1) umfassend:
eine Steuereinrichtung (2);
eine Empfangseinrichtung (3), die ausgebildet ist, ein Kommunikationssignal über ein Long Range Wide Area Netzwerk, LoRaWAN, zu empfangen und an die Steuereinrichtung (2) zu übermitteln; und
eine Anzeigeeinrichtung (5), die ausgebildet ist, Informationen basierend auf einem Anzeigesignal der Steuereinrichtung (2) anzuzeigen;
wobei die Steuereinrichtung (2) ausgebildet ist, das von der Empfangseinrichtung (3) übermittelte Kommunikationssignal in ein Anzeigesignal umzuwandeln und an die Anzeigeeinrichtung (5) zu übermitteln.

2. Kommunikationsvorrichtung (1) nach Anspruch 1, außerdem umfassend Eingabemittel, insbesondere einen Taster (9), zum Bestätigen der Kenntnisnahme der auf der Anzeigeeinrichtung (5) angezeigten, auf dem Kommunikationssignal basierenden Informationen durch eine Bedienperson, wobei die Kommunikationsvorrichtung (1) ausgebildet ist, ein Empfangsbestätigungssignal über das LoRaWAN an ein Gateway zu übermitteln, wenn die Eingabemittel zum Bestätigen betätigt werden.

3. Kommunikationsvorrichtung (1) nach einem der vorangegangenen Ansprüche, außerdem umfassend eine Signalgebeeinrichtung, die ausgebildet ist, ein Audiosignal und/oder ein haptisches Signal auszugeben, wenn ein Kommunikationssignal empfangen wird.

4. Kommunikationsvorrichtung (1) nach einem der vorangegangenen Ansprüche, außerdem umfassend eine Sendeeinrichtung, die ausgebildet ist, Signale drahtlos über das LoRaWAN Netzwerk an eine externe Empfangseinheit zu übermitteln, wobei die Sendeeinrichtung zum periodischen oder aperiodischen Senden eines Ausgangssignals, insbesondere eines Keepalive Signals, ausgebildet ist, und wobei die Empfangseinrichtung (3) ausgebildet ist, ein Kommunikationssignal unmittelbar nach dem Senden des Ausgangssignals zu empfangen und ansonsten zwischen dem periodischen oder aperiodischen Senden des Ausgangssignals in einem Stand-by Modus verbleibt.

5. Kommunikationsvorrichtung (1) nach einem der vorangegangenen Ansprüche, wobei die Anzeigeeinrichtung (5) eine Matrixanzeige, insbesondere eine Flüssigkristallanzeige oder eine OLED-Anzeige, umfasst.

6. Kommunikationssystem umfassend:
eine Kommunikationsvorrichtung (1) nach einem der vorangegangenen Ansprüche;
einen Serverrechner (12); und
eine Sende-Empfangs-Vorrichtung (11), die mit dem Serverrechner (12) verbunden und so ausgebildet ist, dass der Serverrechner (12) mit der Kommunikationsvorrichtung über ein Long Range Wide Area Netzwerk, LoRaWAN, kommunizieren kann.

7. Kommunikationssystem nach Anspruch 6, wobei der Serverrechner (12) und die Sende-Empfangs-Vorrichtung (11) mit einer unterbrechungsfreien Stromversorgung (14), USV, gekoppelt sind.

8. Kommunikationssystem nach Anspruch 6 oder 7, außerdem umfassend eine Vorrichtung zur Überwachung einer Transformatorenstation, umfassend:
wenigstens einen Sensor (15) zur Erfassung eines Betriebszustandes einer Transformatorenstation (25); und
eine mit dem Sensor (15) verbundene Steuerung (10), welche ausgebildet ist, basierend auf einem Messsignal des Sensors (15) ein Übertragungssignal zur drahtlosen Übermittlung über das LoRaWAN Netzwerk zu erzeugen;
wobei die Steuerung (10) außerdem eine Übertragungseinheit (19) umfasst, die ausgebildet ist, das Übertragungssignal drahtlos über das LoRaWAN Netzwerk an den Serverrechner (12) zu übermitteln.

9. Verfahren zum Übermitteln von Text, Abbildungen und/oder Videos über ein Long Range Wide Area Netzwerk, LoRaWAN, umfassend die Schritte:
Konfigurieren von Text, einer Abbildung und/oder einem Video als Kommunikationssignal zur Übermittlung an eine Kommunikationsvorrichtung (1) nach einem der Ansprüche 1 bis 5 in einem Serverrechner (12) eines Long Range Wide Area Netzwerks, LoRaWAN; und
Übertragen des Kommunikationssignals an die Kommunikationsvorrichtung (1) über das LoRaWAN.

10. Verfahren zum Empfangen von Text, Abbildungen und/oder Videos über ein Long Range Wide Area Netzwerk, LoRaWAN, umfassend die Schritte:
Empfangen eines Kommunikationssignals über ein Long Range Wide Area Netzwerk, LoRaWAN, wobei das Kommunikationssignal Informationen für Text, eine Abbildung und/oder ein Video umfasst;
Umwandeln des Kommunikationssignals in ein Anzeigesignal für den Text, die Abbildung und/oder das Video und Übermitteln an eine Anzeigeeinrichtung (5); und
Anzeigen des Texts, der Abbildung oder des Videos mittels der Anzeigeeinrichtung (5).
